# DEMANDE DE BREVET EUROPEEN

(11) **EP 2 736 001 A1**
(43) Date de publication de la demande: **28.05.2014**
(21) Numéro de dépôt: 12306467.7
(22) Date de dépôt: 27.11.2012
(51) Int. Cl.: G06K 19/077

(54) **Module électronique à interface de communication tridimensionnelle**

(71) Demandeur: Gemalto SA, 92190 Meudon (FR)
(72) Inventeur: Fidalgo, Jean-Christophe, 13420 Gemenos (FR); Seban, Frédérick, 13260 Cassis (FR); Ottobon, Stéphane, 83270 Saint Cyr sur Mer (FR); Audouard, Laurent, 13400 Aubagne (FR)

(57) **Abrégé**

L'invention concerne un procédé de fabrication d'un module électronique (16) comprenant une puce de circuit intégré (7) reliée à une antenne (2), ledit procédé comprenant les étapes de :
- réalisation d'un module comprenant des zones d'interconnexion(s) électrique(s) (34A, 34B), une puce (7) connectée aux zones d'interconnexion et une protection (12) recouvrant au moins la puce et en partie lesdites zones d'interconnexion, une antenne radiofréquence (2) reliée à la puce et disposée au dessus de la puce.

Le procédé se distingue en ce qu'il comprend une étape de réalisation de tout ou partie de l'antenne (2) ou de ses pistes de raccordement (32, 33) aux zones d'interconnexion (34A, 34B), en trois dimensions directement sur la protection (12).

## Description

### Domaine de l'invention.

L'invention concerne un module électronique comprenant une puce de circuit intégré connectée à une interface de communication tridimensionnelle notamment à antenne radiofréquence.

L'invention concerne notamment le domaine des supports électroniques tels que cartes à puce à contacts et/ou sans contact ou cartes hybrides, tickets ou étiquettes radiofréquences, transpondeurs radiofréquences, inserts (ou inlay) intégrant ou constituant un tel module. De tels supports électroniques peuvent être conformes notamment au standard ISO / IEC 14443 ou ISO 78016.

Dans une application préférée, le module peut être du type hybride avec une interface à contacts électriques et à antenne radiofréquence. Le module de l'invention peut être simplement un module à antenne. Il peut aussi comprendre une antenne passive ou relais pour une augmentation de la portée de la communication radiofréquence. L'antenne passive et/ou le module peuvent être placés de préférence dans un corps de carte à puce mais aussi tout autre dispositif, par exemple un téléphone sous forme amovible ou soudée.

### Art antérieur.

Il est connu de fabriquer un module de carte à puce par les étapes correspondant au préambule de la revendication 1. De tels modules sont décrits dans le brevet FR 2743649 B1. L'antenne, de type spirale plane, est réalisée sur une face d'un substrat isolant tandis que l'autre face peut comprendre une interface à contacts électrique.

Le document DE-A-43 11 493, décrit une unité d'assemblage pour la fabrication d'unités d'identification au format carte. Selon un premier mode de réalisation, un module de carte à puce comporte un support portant une puce de circuit intégré. Une bobine filaire surmonte la puce sur l'arrière du module à contact de façon à donner au module une capacité d'identification sans contact. L'antenne est vraisemblablement réalisée (bobinée) en dehors du module puis rapportée dessus. La surface de l'antenne est très limitée et ne semble pas permettre une communication de grande portée. La mise en oeuvre de l'antenne en filaire, son report et sa connexion ne sont pas expliqués et ne semblent pas aisés.

### Problème technique.

Des substrats ou module de type double face standard comme décrit dans le brevet FR 2 743 649, portant des interfaces de communication à contact et à antenne sur leurs deux faces opposées et avec des vias conducteurs d'interconnexion sont compliqués et onéreux à réaliser.

En outre, pour des performances optimales, chaque puce radiofréquence nécessite une antenne de conception spécifique et par conséquent un substrat double face spécifique qui lui est dédié. Il est nécessaire de développer un substrat double face différent pour chaque puce et des stocks de substrats ou modules différents sont donc à gérer en fonction de chaque puce.

Le but de l'invention est de réduire les coûts ou étapes de fabrication tout en permettant une souplesse pour ajuster la portée de communication radiofréquence en fonction des puces disponibles.

### Résumé de l'invention.

L'invention consiste à ajouter une antenne ou des spires à un module standard qui peut être simple ou double face. De préférence, les spires additionnelles sont ajoutées par impression de matière conductrice, jet de matière, etc.

L'invention a donc pour objet un procédé de fabrication d'un module électronique (16) comprenant une puce de circuit intégré reliée à une antenne, ledit procédé comprenant les étapes de :
- réalisation d'un module comprenant des zones d'interconnexion électriques, une puce connectée aux zones d'interconnexion et une protection recouvrant au moins la puce et en partie lesdites zones d'interconnexion, une antenne radiofréquence reliée à la puce et disposée au dessus de la puce ;
   Le procédé se distingue en ce qu'il comprend une étape de réalisation de tout ou partie de l'antenne ou de ses pistes de raccordement aux zones d'interconnexion, en trois dimensions directement sur la protection.

Selon d'autres caractéristiques remarquables :
- L'antenne est réalisée par impression notamment jet de matière, jet d'encre conductrice ;
- L'antenne s'étend en partie sur la protection (notamment une matière d'enrobage) à un premier niveau et en partie sur au moins un flanc de la protection jusqu'aux plages /pistes d'interconnexion situées à un second niveau différent du premier niveau ;
- Les pistes d'interconnexion sont reliées à des spires d'antenne complémentaires disposées sur le substrat isolant ;
- Les pistes sont reliées ou constituent des spires d'antenne complémentaires à l'antenne en trois s dimensions ;
- L'antenne en trois dimensions constitue une antenne relais par rapport notamment à un transpondeur contenu au moins en partie dans la matière d'enrobage ;

L'invention également pour objet un dispositif radiofréquence comportant ou constituant le module obtenu selon le procédé.

Brève description des figures.
- Les figures 1-2 illustrent un module de carte à puce de l'art antérieur respectivement en vue de dessus et coupe selon A-A ;
- La figure 3 est une vue de dessus d'un module conforme à l'invention ;
- La figure 4 est une vue en coupe partielle de la figure 3 ;
- La figure 5 est une vue en coupe partielle sensiblement comme la figure 3 mais illustrant un autre mode de réalisation avec un module à double face métallisé et avec des spires complémentaires.

### Description.

Dans les dessins, les mêmes références indiquent des éléments identiques ou similaires.

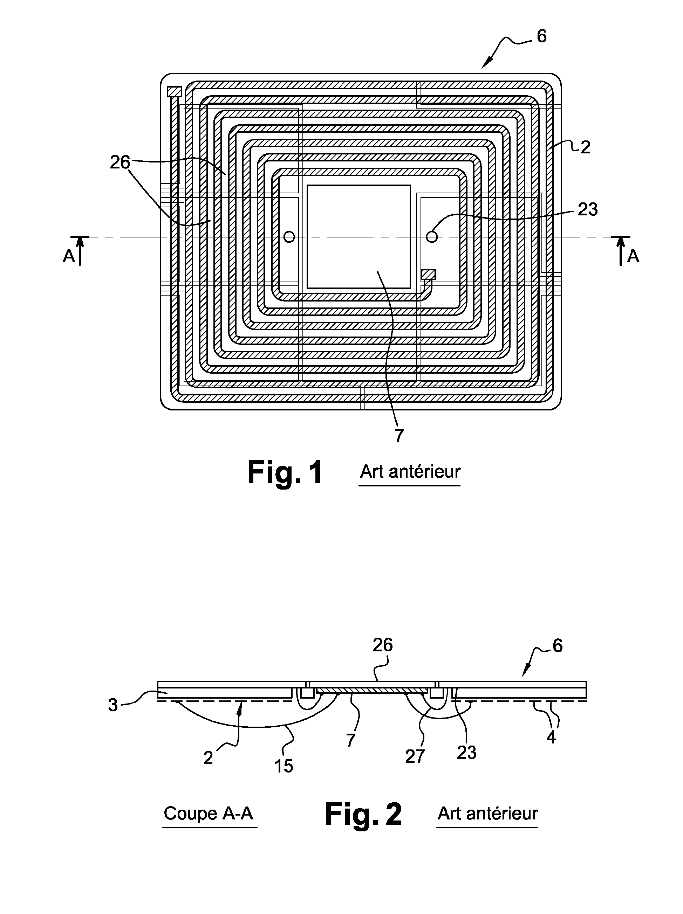

La figure 1 illustre un module 1 de carte à puce de circuit intégré de l'art antérieur en vue de dessus et en coupe A-A. Il comprend une antenne 2 sur un support diélectrique ou isolant 3, notamment du type LFCC (Lead frame contrecollé) ou de type gravé, au moins une puce de circuit intégré 7 reportée sur le support isolant ou sur une plage de contact. L'antenne 2 formée de spires 26 est ici enroulée en spirale sur le support et sensiblement dans un même plan.

Le module comprend également des connexions 15 pour connecter des plots de la puce par fils soudés à des zones d'interconnexion (pistes ou plages conductrices notamment de contact électrique) portées par le support ; Le module comprend un enrobage (non représenté) de la puce et/ou de ses connexions par une résine d'enrobage, déposée sous forme de goutte. La connexion de la puce est réalisée par des connexions filaires traversant des perforations 23 dans le support.

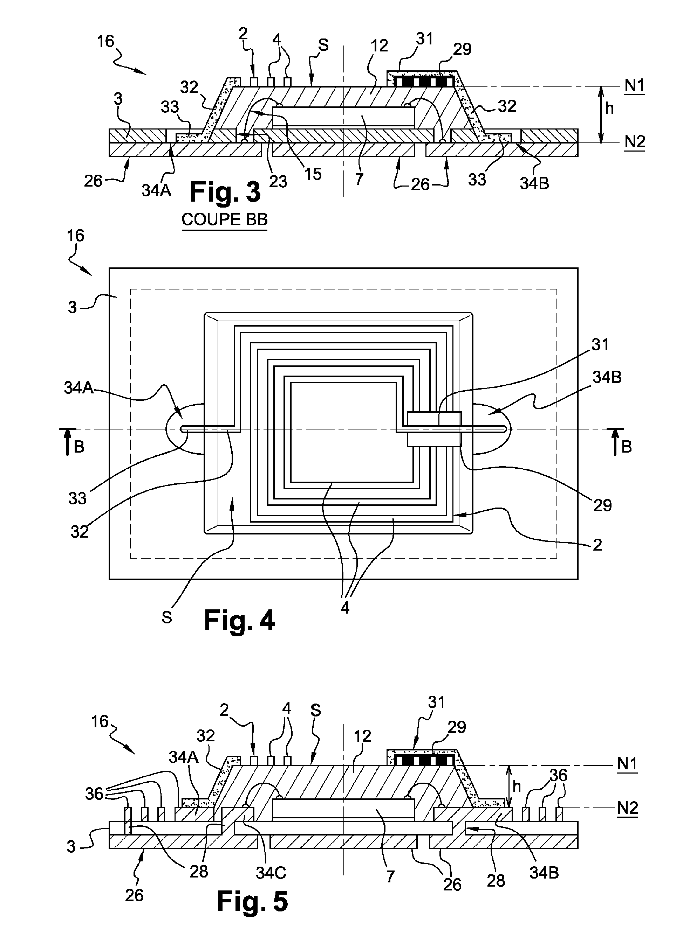

A la figure 3, l'invention prévoit un procédé de fabrication d'un module électronique 16 comprenant une puce de circuit intégré 7 reliée à une antenne 2 formée de spires 4 en spirale.

Le procédé prévoit une première étape de réalisation d'un module 16 comprenant des zones d'interconnexion électriques 26 (plages /pistes), une puce 7 connectée aux zones d'interconnexion et une protection mécanique 12 recouvrant au moins la puce et en partie lesdites zones d'interconnexion.

Les zones d'interconnexion peuvent constituer ou faire partie de plages ou pistes électriques portés par le module. Le substrat isolant porte ici dans l'exemple des plages de contact électriques 26 sur une face externe opposée à la protection. Les zones d'interconnexion font ici partie de ces plages. Elles apparaissent à travers un évidement dans le substrat 3.

La protection est de type mécanique et peut notamment comprendre ou constituer un capot, une résine de type « Dam and Fill » notamment à durcissement UV et présentant un anneau en résine et un remplissage de l'anneau par une autre résine. La protection peut comprendre une pastille isolante disposée sur l'enrobage.

Pour obtenir la meilleure forme des spires ou pistes, le procédé d'encapsulation préféré pourrait être un surmoulage ou une goutte de résine surmontée d'une pastille plate de renfort afin d'obtenir un sommet plat. Toutefois, une impression tridimensionnelle 3D permet de former une antenne sur le sommet standard, en forme de dôme, d'une goutte de résine ou une protection / encapsulation de type à remplissage d'anneau en résine (Dam & fill).

Dans l'exemple, on obtient une protection mécanique par un enrobage 12 obtenue de préférence par surmoulage et/ou de manière à avoir une surface supérieure de l'enrobage S sensiblement plane.

Pour permettre la connexion de l'antenne 2 avec les zones d'interconnexion, l'angle de la pente de la protection peut être correctement défini. Avec le surmoulage, ce paramètre est défini par la forme du moule.

Selon une seconde étape du procédé, on réalise une antenne radiofréquence 2 reliée à la puce et disposée au dessus de la puce (opposée aux plages de contact) selon Y dans le repère XYZ de la figure 3 de manière à avoir la puce entre l'antenne 2 et les plages de contact 26.

Selon une caractéristique de ce mode, le procédé comprend une étape de réalisation de tout ou partie d'une antenne (2) en trois dimensions ou de ses pistes de raccordement (32) aux zones d'interconnexion 34A, 34B, directement sur la protection 12 de la puce 7.

Par antenne tridimensionnelle 2 (en trois dimensions), on entend le fait de réaliser tout ou partie de l'antenne sur plusieurs niveaux N1, N2 selon l'ordonnée Y perpendiculaire aux plages de contact de préférence par impression ou distribution de matière conductrice notamment par buses ou orifices de têtes de jet d'encre à jet continu ou par goutte à la demande selon une technologie piézo électrique, thermique ou encore par valve.

Une partie de l'antenne peut être réalisée directement sur le module (par exemple par projection, tandis qu'une partie peut être rapportée (par exemple, sur une pastille ou un capot).

Dans l'exemple, l'antenne 2 s'étend en partie sur la matière de protection 12 à un premier niveau N1 et en partie sur au moins un flanc de la matière de protection jusqu'aux plages /pistes d'interconnexion 34A, 34B situées à un second niveau N2 différent du premier niveau en suivant un dénivelé h.

La différence entre les niveaux extrêmes N1, N2 (ou dénivelé h) est par exemple compris entre 0,2 et 0,6 mm. Dans le mode de la figure 3, ce dénivelé pourrait être dans la réalité de 0,55 mm (pour un module de 0,58 mm d'épaisseur moins l'épaisseur de la métallisation en cuivre de la face contact d'environ 0,030 mm). Et dans le mode de la figure 5, ce dénivelé pourrait être dans la réalité de 0,38 mm (pour un module de 0,58 mm d'épaisseur moins l'épaisseur du film double face d'environ 0,2 mm). Toujours à la figure 3, dans l'exemple, les spires 4 de l'antenne 2 sont réalisées sur le sommet (S) plat de l'enrobage de protection 12 et les pistes de raccordement de l'antenne s'étendent sur une pente latérale de l'enrobage (ou flanc de l'enrobage), jusqu'aux zones /plages / pistes d'interconnexion 34A, 34B, 26 de l'antenne. Le sommet (S) peut toutefois ne pas être plat, tel un arrondi ou en forme de cratère.

Les zones d'interconnexion 34A, 34B de l'antenne sont ici réalisées par une portion de surface située au verso de plages de contact telle la plage 26 du module. Cette portion est accessible par une ouverture ou perforation dans le film support 3.

La puce est connectée à des plages de contact / zones d'interconnexion par des ouvertures / perforations 23 dans le film support 3. Cela évite notamment d'avoir un film support de type double face (double métallisation).

Le côté externe / apparent du module demeure ici inchangé, permettant ainsi de conserver un bon aspect et avec de bonnes résistances mécaniques / corrosion. Le module nu « lead frame » est de type classique /standard.

Les contacts sont formés par gravure de cuivre ou feuille de cuivre poinçonnée et laminée sur un substrat diélectrique. Les contacts sont traités par un revêtement de surface de type Ni/Cu, Ni/Au ou Ni/Pd ou n'importe quel équivalent.

Ainsi, l'invention selon ce mode de réalisation consiste à ajouter une antenne ou des spires à un module standard simple face sur la protection de la puce. Le procédé prévoit donc au préalable d'effectuer un report et connexion classique de la puce à l'aide d'opérations standards notamment une connexion par fil soudé 15, protection de la puce notamment par enrobage (goutte de résine ou goutte de résine surmontée le cas échéant de raidisseur / pastille isolante) ou surmoulage ou capot ou équivalent.

Selon une caractéristique de ce mode de mise en oeuvre, l'antenne est réalisée par impression notamment jet de matière, jet d'encre conductrice, le cas échéant par sérigraphie, tampographie sur la partie plane (S) éventuellement complétée par jet de matière pour une liaison aux zones d'interconnexion 34A, 34B.

L'impression est de préférence de type tridimensionnel pour réaliser des motifs sur différents niveaux de surface.

Le cas échéant, on peut utiliser une encre d'impression comprenant des particules conductrices. Elles peuvent comprendre des flocons ou des nanoparticules. Les particules conductrices peuvent comprendre différents métaux : Ag, Cu, Au, A1, Ni.

Après l'impression, l'encre peut être séchée pour supprimer tous les solvants et puis être polymérisée. Cette étape de durcissement permet d'atteindre la meilleure valeur de conductivité électrique. Dans le cas des nanoparticules, le procédé choisi permettra aux particules d'atteindre le frittage. Ceci est possible grâce à un four à infrarouge, un tunnel d'air chaud, un traitement à micro-ondes ou un système de lumière pulsée.

Pour obtenir la résistance mécanique et conductivité électrique désirée, l'impression et l'opération de séchage peuvent être appliqués plusieurs fois pour augmenter l'épaisseur.

L'antenne ainsi formée permet de doter le module d'une interface sans contact 2 en toute dernière opération selon le type de puce disponible et /ou portée de communication nécessaire.

Cette impression d'antenne peut requérir un pont isolant 29 recouvrant des spires 4 réalisées notamment avec une encre isolante et un deuxième passage d'encre conductrice à imprimer afin de réaliser un pont conducteur 31 par-dessus le pont isolant pour connecter la spire interne de l'antenne 2 à la puce via la zone d'interconnexion 34B.

A la figure 5, le module diffère du précédent en ce que les zones d'interconnexion conductrices (métallisations) 34A, 34B du module sont situées sur le verso du support (face opposée à la face portant les plages de contact), ici un support à deux faces opposées conductrices. Des vias conducteurs 28 peuvent relier les métallisations 34A, 34B ou autre situées sur les faces opposées.

Alternativement, l'invention peut aussi prévoir un double face sans via conducteur et/ou sans spires supplémentaires à celle qui sont sur la protection.

Ce mode diffère aussi du précédent en ce qu'il comprend des spires ou parties d'antenne (cas UHF) s'étendant en dehors de la protection. Ces parties d'antenne hors de la protection peuvent aussi s'appliquer au mode précédent.

De manière générale, sur chaque mode, l'antenne 2 reliée à la puce radiofréquence 7 peut être utilisée seule ou en combinaison avec un «circuit d'amplification LC » appelé aussi «booster RF» ou antenne relais ou antenne passive.

Dans le cas de l'antenne utilisée seule, elle peut être une conception RF, UHF, UWB ou n'importe quel type de fréquence notamment allant de quelques MHz jusqu'à quelques GHz.

En option sur cette figure 5, des spires 36 d'antenne peuvent aussi recouvrir la surface du module située en périphérie de l'encapsulation ou de la protection mécanique 12 de la puce. Ces spires 36 peuvent être préformées comme les plages de contact ou formées par impression sur l'une quelconque face du module.

Les spires 36 peuvent être gravées sur la face arrière du module. Le cas échéant, un autre pont isolant sur ou sous ces spires 36 peut être créé, notamment par impression, pour permettre de rejoindre une spire externe formée sur le support. Ces spires supplémentaires permettent un plus grand nombre de tours ou une plus grande surface pour quelques tours.

Dans l'exemple, la spire interne de l'association formée par les deux séries de spires 4, 36, est connectée à la zone 34B sensiblement comme à la figure 4. La spire externe 4 de l'antenne 2 est reliée à une zone d'interconnexion 34A ; Cette zone 34A est ensuite reliée à une spire interne des spires 36 de manière à augmenter le nombre de tour de l'antenne 2 ; La spire externe des spires 36 est connectée à la puce par un pont conducteur passant sous les spires 36 par l'intermédiaire de la plage 26 et de vias conducteurs 28 et zone d'interconnexion 34C à la puce.

Le cas échéant, l'invention peut prévoir un matériau isolant qui peut être imprimé sur le module autour de la protection / encapsulation pour recouvrir et isoler des pistes résiduelles et éventuelles d'amenées de courant utilisées notamment pour effectuer des dépôts électrolytiques.

De manière avantageuse dans chaque cas, il est en général possible d'apporter de la sécurité anti-fraude contre le démontage d'une carte à puce. Une goutte de colle peut être déposée dans le fond de cavité d'un corps de carte avant l'encartage du module selon l'invention ; La colle adhère nécessairement à l'antenne 2 et l'extraction frauduleuse du module de sa cavité provoquera une rupture ou endommagement (difficilement réparable) de l'antenne 2 qui avait été imprimée ou réalisée sur la protection mécanique 12.

Selon une caractéristique, les pistes d'interconnexion 34A, 34B peuvent être déjà pré-reliées à des spires 36 d'antenne complémentaires disposées sur le substrat isolant. En effet, le support 3 peut comprendre des spires d'antenne complémentaires aux spires de l'antenne 2 en trois dimensions.

De préférence, les plages / pistes / zones d'interconnexion 34A, 34B, 26 décrites aux modes précédents, sont portées par un substrat isolant. Toutefois l'invention prévoit aussi de ne pas avoir de substrat isolant, les zones diverses d'interconnexion étant portées ou reliées ensemble par une résine ou capot de protection de la puce.

Dans un troisième mode de mise en oeuvre de l'invention, l'antenne additionnelle 4 des figures 3 ou 5), est formée de la façon ci-après. On dépose au dessus de la puce 7 ou son enrobage, une pastille isolante de renfort ou un capot qui comprend déjà des pistes ou spires d'antenne ; Puis dans un second temps, on réalise une connexion des pistes ou spires portées par la pastille ou capot aux zones d'interconnexion 34A, 34B résidant sur le module. La connexion peut être faite par tout moyen connu (soudure...) mais l'impression est préférée pour une souplesse opératoire.

Le cas échéant, si nous voulons que le transpondeur radiofréquence du module soit destiné à fonctionner avec une antenne relais / passive, il est possible de réaliser l'antenne relais sur le module notamment dessus et/ou en périphérie de la protection mécanique et notamment par impression.

Selon un autre mode de réalisation non illustré, l'antenne tridimensionnelle 2 des modes précédents peut constituer une antenne relais par rapport notamment à un transpondeur contenu au moins en partie dans la protection mécanique 12.

Alternativement, selon un mode de réalisation non illustré, les spires 36 du module 16 de la figure 5 ou 3, peuvent constituer une antenne passive en périphérie du module par rapport au transpondeur constitué par la puce 7 et l'antenne 2. Dans ce cas, l'antenne 2 ne serait pas connectée aux spires 36 de l'antenne passive mais à la puce 7 comme à la figure 3. Et les spires complémentaires 36 formant antenne relais seraient connectées à une capacité d'une forme quelconque telle que décrite précédemment.

Le transpondeur peut être simplement une puce reliée à une antenne, notamment gravée / imprimée sur une face de la puce. L'antenne relais peut aussi être réalisée au verso du module (face opposée à celle portant les plages 26) et/ou sur la mécanique 12.

Une capacité reliée à l'antenne relais peut être prévue sur le module, notamment sous forme de circuit intégré monté en surface ou de plaques de condensateur. L'antenne relais peut être connectée via des zones d'interconnexion (similaires à 34A, 34B) à une capacité sous forme de puce électronique disposée, par exemple, à coté de la puce 7. Alternativement, les zones 34A, 34B peuvent former une capacité avec des plages conductrices 26 portées par le substrat.

D'une manière générale, l'antenne du transpondeur radiofréquence destiné à fonctionner avec une antenne relais peut être portée soit par la puce, soit sur le substrat isolant.

L'antenne tridimensionnelle peut comprendre un ou plusieurs pont(s) isolant(s) sur les spires pour ramener une spire interne vers une spire externe ou vice versa par-dessus ou dessous ce pont isolant.

La description ci-après décrit plus amplement l'intérêt du module radiofréquence de l'invention eu égard à une antenne relais. Dans un mode particulier de réalisation non illustré, pour augmenter la portée de communication sans contact, l'antenne 2 du module de l'un quelconque mode de réalisation, est de préférence couplée électro-magnétiquement à une antenne passive.

L'antenne passive peut être disposée dans un corps de carte ou passeport ou un lecteur ou tout dispositif radiofréquence. Le cas échéant, l'antenne est disposée dans ou sur un téléphone portable ou assistant personnel électronique, notamment dans le boîtier. L'antenne passive peut être réalisée par exemple en fil incrusté, par gravure, selon une technologie d'étiquette électronique etc.

Quel que soit le mode de réalisation, avec ou sans antenne relais, l'invention peut prévoir des formes et/ou connexions, plages de contact, plages de soudure ou de connexion de manière à ce que le module soit adapté pour être amovible ou soudé sur un dispositif électronique quelconque tel un téléphone mobile ou un ordinateur personnel (PDA).

Même sur un corps de carte, le module peut être adapté pour être détachable avec notamment un adhésif repositionnable placé sur la surface de collage. Ainsi, le support peut ne pas dépasser la surface de la protection mécanique ou enrobage. Il peut avoir un format réduit des nouvelles normes 3FF, 4FF. Il peut être adapté avec des pattes de fixation pour être monté en surface d'un circuit imprimé.

L'invention offre un meilleur compromis fiabilité, aspect module, souplesse de fabrication et le coût par rapport à un film double face de vias conducteurs et antenne complètement gravée.

Un module standardisé pour une production peut être stocké selon une forme ou modèle générique et il sera personnalisé en imprimant l'antenne adaptée aux caractéristiques distinctes de chaque puce. L'utilisation du module à double interface avec antenne permettra une augmentation significative du débit des données pour l'étape de personnalisation et donc de réduire les coûts.

La conception de l'antenne imprimée permet un réglage au dernier moment de l'antenne : si par exemple un lot de puces présente une résistance interne d'une valeur différente de celle standardisée prévue pour la production, l'invention permet de changer le nombre de spires de l'antenne de manière à conserver la même fréquence de résonance résultante.

Un autre intérêt de l'invention est le fait qu'un module standard à double interface peut être connecté à une antenne noyée dans un corps de carte comme dans l'art antérieur avec des zones de connexion mises à jour ou étant accessibles de l'extérieur du corps de carte ou lors de l'encartage. Une interconnexion de l'antenne du corps de carte avec le module peut s'effectuer par tout moyen notamment avec une colle argent ou des plots conducteurs flexibles.

## Revendications

1. Procédé de fabrication d'un module électronique (16) comprenant une puce de circuit intégré (7) reliée à une antenne (2), ledit procédé comprenant les étapes de:
- réalisation d'un module comprenant des zones d'interconnexion(s) électrique (s) (34A, 34B), une puce (7) connectée aux zones d'interconnexion et une protection (12) recouvrant au moins la puce et en partie lesdites zones d'interconnexion, une antenne radiofréquence (2) reliée à la puce et disposée au dessus de la puce,
**caractérisé en ce qu'il** comprend une étape de réalisation de tout ou partie de l'antenne (2) ou de ses pistes de raccordement (32, 33) aux zones d'interconnexion (34A, 34B), en trois dimensions directement sur la protection (12) .

2. Procédé selon la revendication précédente, **caractérisé en ce que** l'antenne (2) est réalisée par impression, notamment jet de matière ou jet d'encre conductrice.

3. Procédé selon la revendication précédente, **caractérisé en ce que** ladite antenne (2) s'étend en partie sur la protection (12) à un premier niveau N1 et en partie sur au moins un flanc de la protection jusqu'aux zones d'interconnexion (34A, 34B) situées à un second niveau N2 différent du premier niveau.

4. Procédé selon la revendication précédente, **caractérisé en ce que** lesdites zones d'interconnexion (34A, 34B) sont portées par un substrat isolant (3).

5. Procédé selon l'une des revendications précédentes, **caractérisé en ce que** les zones d'interconnexion (34A, 34B) sont reliées à des spires d'antenne complémentaires (36) disposées sur le substrat isolant.

6. Procédé selon la revendication précédente, **caractérisé en ce que** les zones d'interconnexion (34A, 34B) sont reliées ou constituent des spires d'antenne complémentaires (36) à l'antenne (2) en trois dimensions.

7. Procédé selon la revendication précédente, **caractérisé en ce que** l'antenne en trois dimensions (2) constitue une antenne relais par rapport à un transpondeur (7) contenu au moins en partie dans la protection.

8. Procédé selon la revendication précédente, **caractérisé en ce que** l'antenne du transpondeur est portée soit par la puce (7) soit sur le substrat isolant (3).

9. Procédé selon l'une des revendications précédentes, **caractérisé en ce que** le substrat isolant porte des plages de contact électriques (26) sur une face externe opposée à l'enrobage.

10. Procédé selon l'une des revendications précédentes, **caractérisé en ce que** l'antenne tridimensionnelle comprend un pont isolant sur les spires pour ramener une spire interne vers une spire externe par-dessus ce pont isolant.

11. Dispositif radiofréquence comportant ou constituant le module obtenu selon l'une quelconque des revendications précédentes.
